# EUROPEAN PATENT APPLICATION

(11) **EP 0 550 962 A2**
(43) Date of publication of application: **14.07.1993**
(21) Application number: 92310665.2
(22) Date of filing: 23.11.1992
(51) Int. Cl.: H01L 29/73, H01L 21/331

(54) **Heterojunction bipolar transistor**

(30) Priority: 08.01.1992 US 818019
(71) Applicant: AT&T Corp., New York, NY 10013-2412 (US)
(72) Inventor: Jalali-Farahani, Bahram, South Hempstead, New York 11550 (US); King, Clifford Alan, NY, New York 10003 (US)
(74) Representative: Watts, Christopher Malcolm Kelway, Dr.

(57) **Abstract**

A heterojunction bipolar transistor (HBT), and a method for forming the HBT are described. The base of the HBT includes intrinsic (130) and extrinsic (140, 150) base regions. In contrast to the prior art, the HBT omits an oxide spacer layer between the emitter and base regions, and instead, a portion (150) of the extrinsic base abuts and directly contacts the emitter region (160). In further contrast to the prior art, the intrinsic base is not more than about 500 Å thick.

## Description

### Field of the Invention

This invention relates to a heterojunction bipolar transistor, and to methods for its manufacture.

### Art Background

Heterojunction bipolar transistors (HBTs) have been previously described. For example, U.S. Patent No. 5,006,912, issued to C. Smith, et al. on April 9, 1991, describes such a transistor in which the base comprises a layer of silicon-germanium alloy. One important factor in designing HBTs, in general, is the need to prevent current flow between the base contact layer and the emitter, bypassing the active base region. In prior art approaches, such short-circuit behavior has generally been prevented by incorporating an oxide spacer between the emitter or emitter contact region and abutting portions of the base or base contact region. Such spacers are undesirable because they tend to increase the base resistance and incur additional fabrication steps for the purpose of linking up the intrinsic and extrinsic bases, i.e., those base portions which lie, respectively, centrally and peripherally relative to the emitter. Alternative approaches have involved selective etch techniques for removing material down to a very thin epitaxial base layer, but no farther. Such techniques are undesirable because they are difficult to control with the required precision.

### Summary of the Invention

We have discovered an HBT, and a method for manufacturing the HBT, in which a portion of the extrinsic base abuts and directly contacts the emitter region. Such an HBT is formed on a principal surface of a single-crystalline silicon substrate portion of a first conductivity type which is, of course, either p-type or n-type. Contactingly overlying at least a portion of the principal surface is a substantially undoped silicon region, referred to as an "intrinsic" silicon layer. Some residual impurities are expected to be present in such a layer, generally resulting in n-type residual doping. By "substantially undoped" is meant that either no dopants are deliberately added to the intrinsic layer, or if any are added, the amounts added, and the resulting conductivities, are comparable to the residual levels. In a general sense, the inventive HBT further comprises: a silicon subcollector region of a second conductivity type opposite to the first conductivity type, the subcollector region contactingly overlying at least a portion of the intrinsic silicon layer; a silicon collector region of the second conductivity type contactingly overlying at least a portion of the subcollector region; a base region of the first conductivity type contactingly overlying at least a portion of the collector region and forming a pn junction therewith; and a silicon emitter region of the second conductivity type which forms a pn junction with the base region. The emitter region overlies a first portion of the base region, to be referred to as the intrinsic base." The emitter region does not overlie a second portion of the base region, to be referred to as the "extrinsic base." (As applied to the base, the terms "intrinsic" and "extrinsic" thus refer to a geometrical feature and are unrelated to doping level.) Furthermore, the intrinsic base comprises a single-crystalline silicon-germanium alloy having a germanium mole fraction which is at least about 0.1 and not more than about 0.5; the intrinsic base is no more than about 500 Å thick; and a portion of the extrinsic base abuts and directly contacts the emitter region along an interface disposed substantially perpendicular to the principal surface.

In a second sense, the invention involves a method for fabricating a heterojunction bipolar transistor on a principal surface of a portion of a single-crystalline silicon substrate, the substrate portion having a first conductivity type. The method comprises the steps of: growing a first, substantially undoped silicon layer on the principal surface by vapor-phase epitaxy (VPE); by ion implantation, imparting to at least an upper portion of the first layer (to be referred to as the "subcollector layer") a second conductivity type opposite to the first conductivity type; growing a silicon collector layer on the subcollector layer by VPE; growing an intermediate silicon layer on the collector layer by VPE; growing a layer of silicon-germanium alloy, to be referred to as the "base layer," on the intermediate layer by VPE; growing a silicon emitter layer on the base layer by VPE; implanting ions into an upper portion of the emitter layer (to be referred to as the "emitter contact layer") such that conductivity of the second type is imparted to the emitter contact layer; and defining, in the intermediate silicon layer, the base layer, the emitter layer, and the emitter contact layer a central region and a peripheral region such that the central regions are substantially vertically aligned and of substantially the same lateral extent. The method further comprises the step of implanting ions in each of the peripheral regions such that implanted ions are substantially excluded from each of the central regions, and such that conductivity of the first type is imparted to each of the peripheral regions. The implantation step is performed such that there results, in the completed transistor, an abutment between the peripheral region of the emitter layer and the central emitter region. The method further comprises the steps of removing the peripheral portion of the emitter contact layer, and completing the formation of the transistor.

### Brief Description of the Drawings

FIG. 1 is a schematic, cross-sectional representation of the inventive transistor, in one embodiment.

FIGS. 2 - 8 are schematic, cross-sectional representations of successive stages in the fabrication of the transistor of FIG. 1.

FIG. 9 is a plot of the collector characteristic curves measured for an exemplary transistor made according to the invention.

### Detailed Description

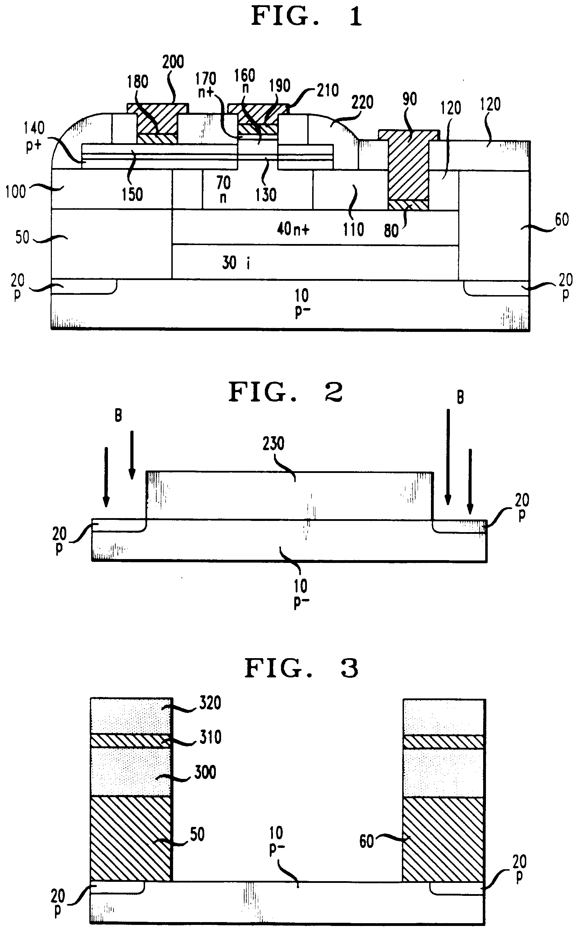

A currently preferred embodiment of the invention is now described with reference to FIG. 1. In such embodiment, the invention is, e.g., an npn heterojunction bipolar transistor (HBT) formed on a single-crystalline silicon substrate 10, which is p-type for purposes of the illustrative npn device. Formed in a near-surface portion of the substrate are p-type channel-stop regions 20. The channel-stop regions are conventional, and need not be described here in detall. Overlying a surface portion intermediate the channel-stop regions is epitaxially grown, nearly intrinsic silicon region 30, which typically has no intentional doping and is residually n-type with a residual resistivity of about 100 Ω-cm. Region 30 is exemplarily about 1.5 µm in thickness. During operation of the inventive transistor, region 30 is typically depleted of charge carriers. This is very advantageous because such depletion effectively interposes a wide dielectric region between the active portions of the device and substrate ground, resulting in a reduction of parasitic capacitance.

Overlying region 30 is highly doped, n-type subcollector region 40, exemplarily about 0.5 µm thick. Insulating field oxide regions 50 and 60 substantially surround regions 30 and 40. Overlying a portion of subcollector 40 is n-type collector 70, and overlying a physically separated portion of the subcollector is collector contact region 80, which is overlain, in turn, by collector electrode 90. Collector 70 is exemplarily about 0.1 - 0.5 µm thick. The collector is laterally physically isolated by insulating oxide regions 100 and 110. Insulating oxide regions 110 and 120 provide vertical isolation between the upper (i.e., distal the substrate) surface of the subcollector and the upper portion of the collector electrode.

Overlying at least a portion of collector 70 is intrinsic base 130. (As noted, above, the term "intrinsic" in this context refers to the geometrical structure of the base, and not to its doping level.) The intrinsic base is a p⁺⁺ doped, epitaxially grown layer of silicon-germanium alloy, Si₁₋ₓGeₓ, where x lies typically in the range 0.1 - 0.5, and is exemplarily about 0.3. The intrinsic base is not more than about 500 Å thick, and is typically at least about 50 Å thick. Overlying the intrinsic base is n-type emitter 160, exemplarily about 2000 Å thick. Adjacent the intrinsic base and extending laterally therefrom is the extrinsic base, which includes portions 140 and 150. The extrinsic base is exemplarily about 2500 Å thick. The extrinsic base is doped p⁺⁺. Portion 140 is typically at least partially composed of polycrystalline silicon, whereas portion 150 generally includes a substantial amount of epitaxial silicon, the extent of which depends upon the alignment tolerance during fabrication. Significantly, and in contrast to the prior art, portion 150 of the extrinsic base is not only adjacent to emitter 160, but is also in direct physical contact with it along a substantially vertical interface.

Overlying a portion of extrinsic base portion 140 are base contact region 180 and base electrode 200. Overlying emitter 160 are n⁺ doped emitter contact region 170, emitter TiW contact region 190, and emitter electrode 210. The emitter mesa, which includes regions 160, 170, 190, and 210, is physically isolated by insulating oxide region 220.

Intrinsic base 130 differs in several important respects from the base regions of prior art HBTs. That is, the thickness of the intrinsic base, which lies exemplarily in the approximate range 50 Å - 500 Å, is less than that of more typical base layers in conventional HBTs, which are generally at least 500 Å thick. Moreover, the mole fraction of germanium, which, as noted, typically lies in the range 0.1 - 0.5, is greater than that of most other reported Si-Ge base layers, which typically contain no more than about 7 - 10 mol.% germanium. Still further, the germanium mole fraction is typically not graded within the intrinsic base, but instead is substantially constant throughout the thickness of the base. By "substantially constant" is meant that the germanium mole fraction varies by no more than about 1% - 2% within the interior of the intrinsic base, and the interfacial regions, where greater variation may take place, are no more than about 5 Å thick, or no more than about 10% of the total intrinsic base thickness. (It should be noted, however, that it is not essential for the germanium mole fraction to be constant, and the invention is also intended to encompass alternate embodiments in which the germanium mole fraction is graded.) Still further, as noted above, the extrinsic base is in direct contact with the emitter.

The above-described, novel properties of the inventive transistor have several desirable results. For example, the presence of a heterojunction between the Si-Ge base and the emitter relaxes the usual constraint that the emitter should be more highly doped than the base. (See, for example, H. Kroemer, Proc. IRE 45, pp. 1535 - 1537 (1957).) As a result, the base can be more highly doped than in conventional bipolar transistors, resulting in higher performance without a substantial sacrifice of current gain.

The inventive transistor is also readily made to be symmetric with respect to interchange of the emitter and collector. As a result, "collector-up" operation (wherein the direction of electron current flow is upward) is possible. Because the transistor is also readily made with relatively low collector-substrate capacitance, high-speed circuit operation is enhanced. The combination of symmetry and high speed makes feasible a higher level of integration than is attainable with conventional bipolar transistor technology. In regard to the high operating speed attainable with the inventive transistor, it should also be noted that collector-base capacitance is readily reduced by disposing the extrinsic base region over a relatively thick oxide layer (layer 100 of FIG. 1).

The novel structural features of the inventive transistor also affect at least some potential processes for fabricating the transistor. For example, the presence of a heterojunction makes it possible to self-align the emitter and base using a combination of epitaxy and ion implantation. That is, if there were no heterojunction, the extrinsic base would need to be isolated from the emitter. Such isolation would require additional steps, such as a step of conformal oxide deposition, followed by reactive ion etching. Absent the heterojunction, failure to isolate the extrinsic base from the emitter would result in a loss in injection efficiency, and thus a loss in current gain, due to substantial electron injection into the extrinsic base region. This problem is avoided by the heterojunction because (in, illustratively, an npn device) it leads to a potential barrier for injection of electrons from the emitter into the silicon-germanium intrinsic base which is lower than the corresponding barrier for injection into silicon portions of the extrinsic base. Moreover, ion implantation techniques are readily used to impart a high doping level to the extrinsic base. Still further, all of the junction regions of the inventive transistor are readily grown *in situ* in an epitaxial growth chamber, without interrupting the process by withdrawing the substrate from the chamber.

An exemplary sequence of steps in the fabrication of the above-described transistor will now be described, with reference to FIGS. 2 - 8.

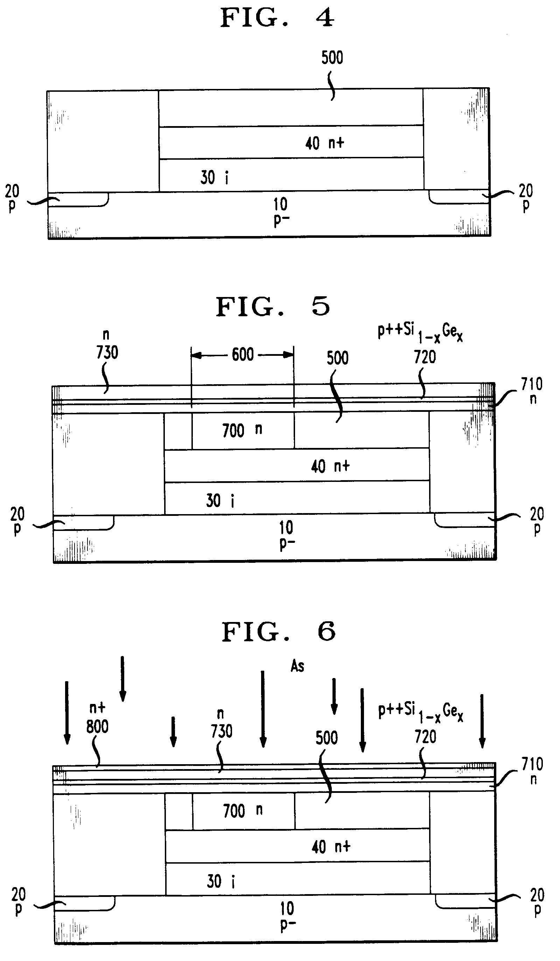

Turning now to FIG. 2, photoresist 230 is first applied to substrate 10, and channel stop regions 20 are conventionally formed by implantation of boron ions. Turning to FIG. 3, oxide regions 50 and 60 are then conventionally formed by growing about 2 µm of field oxide, applying a tri-level resist (i.e., resist 300, oxide 310, and resist 320), exposing the resist, performing, e.g., a tri-level etch, and selectively removing the field oxide by reactive ion etching (RIE). Turning to FIG. 4, epitaxial silicon regions 30 and 40 are then formed by stripping the resist, growing a sacrificial oxide followed by a 100:1 hydrofluoric acid etch, and selective epitaxial growth of regions 30 and 40 (see also FIG. 1). Significantly, the selective epitaxial growth takes place, to a substantial degree, only on exposed, single-crystal silicon surfaces, and therefore forms no substantial silicon layer on the surface of the oxide. (Techniques of selective epitaxial growth are well known in the art, and are described, for example, in B.D. Joyce and J.A. Baldrey, "Selective Epitaxial Deposition of Silicon," Nature 195 (1962) 485 - 486.) Subcollector region 40 is then defined by ion implantation of arsenic, at an exemplary flux of about 5 × 10¹⁵cm⁻² and at exemplary energies of about 30 keV and 100 keV. The oxide layer is then conventionally etched back to a height appropriate to form a planar surface, exemplarily a height of about 0.22 µm above the surface of the silicon layer. Oxide layer 500 is then thermally grown. Turning to FIG. 5, preparation is next made for epitaxial growth of the active device regions. Window 600 is made in oxide layer 500 by conventional application and patterning of a tri-level resist, followed by oxide RIE, sacrificial thermal oxide growth, and etching in 100:1 hydrofluoric acid.

Reactors for vapor-phase epitaxy are well known in the art. A suitable reaction chamber is described, for example, in J.F. Gibbons, et al., "Limited Reaction Processing: Silicon Epitaxy," Appl. Phys. Lett. 47 , pp. 721 - 723. According to the inventive technique, the substrate is next placed within the epitaxial growth chamber. Silicon layer 700, which will correspond to the collector, is first grown from dichlorosilane by selective epitaxial growth (SEG). Silicon layer 710 is then grown from silane by non-selective epitaxial growth. (The choice of gas is significant because the concentration of HCl in the gas stream appears to determine the amount of selectivity; i.e., the degree to which growth will tend to be confined to single-crystalline surfaces.) The portions of layer 710 which overlie epitaxial silicon layer 700 grow epitaxially, thus forming single-crystalline silicon. However, the portions of layer 710 which overlie oxide regions grow substantially as polycrystalline silicon (also referred to herein as "polysilicon"). Si-Ge base layer 720 is then grown by non-selective epitaxial growth from dichlorosilane and germane. An exemplary gas flow for growing a 30 at.% germanium layer includes 80 sccm dichlorosilane, 11 sccm germane, and 20 Lpm (liters per minute) hydrogen. *In situ* doping of the base layer is achieved by adding diborane (B₂H₆) to the gas flow. A typical growth temperature is about 630°C. Like layer 710, layer 720 forms a polysilicon region and an epitaxial, single-crystalline region. Layer 730, corresponding to the emitter region, is then non-selectively, epitaxially grown from dichlorosilane. Like the preceding two layers, layer 730 forms a polycrystalline region and a single-crystalline region.

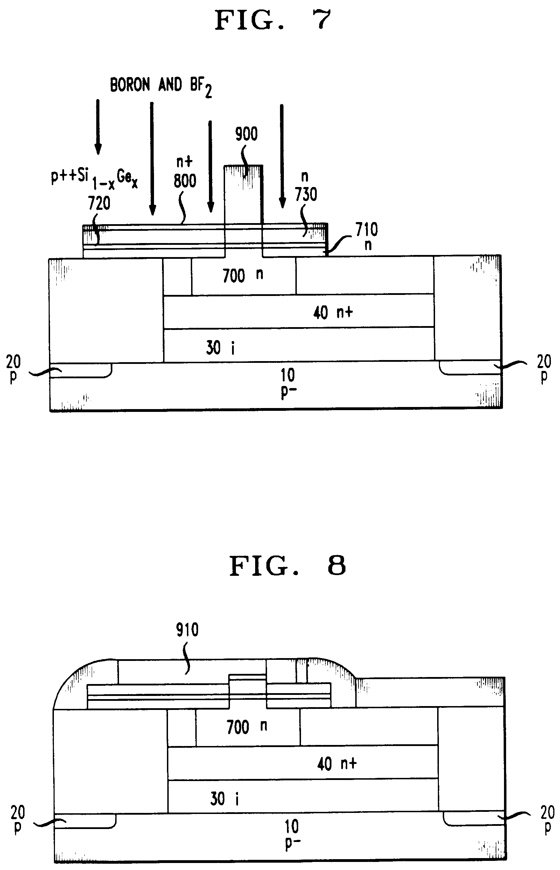

Turning now to FIG. 6, the n⁺ emitter contact region (region 170 of FIG. 1) is formed by implantation of arsenic ions in a thin upper portion of layer 730, thus defining layer 800. The ion implantation is carried out at an exemplary flux of about 5 × 10¹⁵cm⁻² and an exemplary energy of about 30 keV. Turning now to FIG. 7, layers 710, 720, 730, and 800 are conventionally patterned by reactive ion etching of the polysilicon portions through a patterned, tri-level resist. Nitride region 900 is then formed by plasma deposition of a 5000-Å silicon nitride layer at about 300°C, followed by reactive ion etching through a patterned, tri-level resist. The extrinsic base region is then formed by ion implantation of boron and boron difluoride into layers 710, 720, 730, and 800. Exemplary implantation energies and fluxes, respectively, are boron difluoride at 45 keV and 10¹⁵cm⁻², boron at 30 keV and 10¹⁵cm⁻², and boron at 30 keV and 3 × 10¹⁵cm⁻².

Turning now to FIG. 8, layers 730 and 800 are conventionally etched, using nitride layer 900 as an etch mask, to separate the p⁺ from the n⁺ regions, thus isolating the emitter. Because of transverse straggle, implanted boron ions may tend to encroach into n⁺ region 170 (see FIG. 1). This effect is counteracted by oxidizing the affected portion of region 170. Exemplarily, this is done by high pressure oxidation at about 750°C for about 40 minutes. The high pressure oxidation step also results in the growth of oxide layer 910, which is exemplarily about 2000 Å thick.

Layer 900 is then removed by etching in hot phosphoric acid, followed by low-pressure chemical vapor deposition of an additional oxide layer 1000 Å thick. This is followed by a rapid thermal anneal, exemplarily at about 850°C for about 10 seconds. Turning back to FIG. 1, base, emitter, and collector contact holes are conventionally formed by RIE oxide etching through a patterned tri-level resist. Contact layers 80, 180, and 190 (see FIG. 1) are formed by depositing a 1500 Å thick layer of titanium-tungsten alloy (TiW). Electrodes 90, 200, and 210 are then formed by depositing a 1 µm thick layer of aluminum-copper alloy (1% copper) followed by reactive ion etching of the aluminum and TiW layers through a patterned, tri-level resist. This is followed by an anneal in hydrogen at 400°C for 30 minutes.

### Example

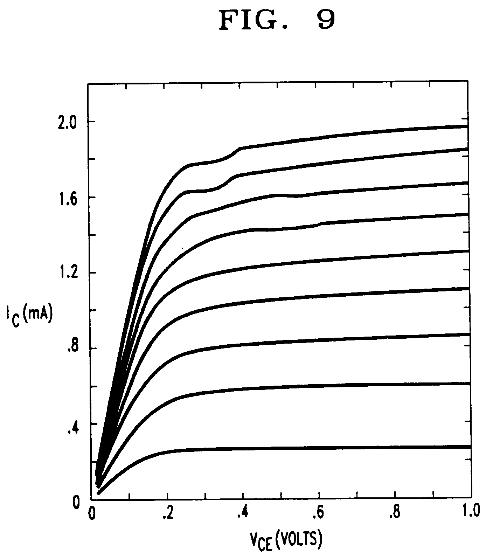

An HBT was made, substantially as described above, having an emitter length of 10 µm and an emitter width of 2 µm. Collector characteristic curves were measured, and are shown in FIG. 9. It is evident from the figure that current gains greater than 100 were obtained, and the transistor performance compared favorably with conventional silicon bipolar transistors. Oscillations evident in the upper several curves of FIG. 9 are an artifact of the measurement technique.

## Claims

1. A heterojunction bipolar transistor formed on a principal surface of a single-crystalline silicon substrate portion of a first conductivity type, said transistor comprising: a substantially undoped silicon region contactingly overlying at least a portion of the principal surface; a silicon subcollector region of a second conductivity type opposite to the first conductivity type, the subcollector region contactingly overlying at least a portion of the substantially undoped region; a silicon collector region of the second conductivity type contactingly overlying at least a portion of the subcollector region; a base region of the first conductivity type contactingly overlying at least a portion of the collector region and forming a pn junction therewith; and a silicon emitter region of the second conductivity type which forms a pn junction with the base region, the emitter region overlying a first portion of the base region, to be referred to as the "intrinsic base," and not overlying a second portion of the base region, to be referred to as the "extrinsic base,"
CHARACTERIZED IN THAT
a) the intrinsic base comprises a single-crystalline silicon-germanium alloy having a germanium mole fraction which is at least about 0.1 and not more than about 0.5;
b) the intrinsic base is not more than about 500 Å thick; and
c) a portion of the extrinsic base abuts and directly contacts the emitter region along an interface disposed substantially perpendicular to the principal surface.

2. The transistor of claim 1, wherein the germanium mole fraction is substantially constant throughout the intrinsic base.

3. A method for forming a heterojunction bipolar transistor on a principal surface of a portion of a single-crystalline silicon substrate, said substrate portion having a first conductivity type, the method comprising the steps of:
a) growing a first, substantially undoped silicon layer on the principal surface by vapor-phase epitaxy;
b) implanting ions into at least an upper portion of the first layer, said upper portion to be referred to as the "subcollector layer," such that a second conductivity type opposite to the first conductivity type is imparted to said subcollector layer;
c) growing a second silicon layer, to be referred to as the "collector layer," on the subcollector layer by vapor-phase epitaxy;
d) growing a layer of silicon-germanium alloy, to be referred to as the "base layer," over the collector layer by vapor-phase epitaxy;
e) growing a third silicon layer, to be referred to as the "emitter layer," on the base layer by vapor-phase epitaxy;
f) implanting ions into an upper portion of the emitter layer, said upper portion to be referred to as the "emitter contact layer," such that conductivity of the second type is imparted to said emitter contact layer; and
g) completing the formation of the transistor;
CHARACTERIZED IN THAI
the method further comprises the steps of:
h) after (c) and before (d), growing a fourth silicon layer between the collector and base layers by vapor-phase epitaxy;
i) after (f), defining, in the fourth silicon layer, the base layer, the emitter layer, and the emitter contact layer a central region and a peripheral region such that the central regions are substantially vertically aligned and of substantially the same lateral extent;
j) after (i), implanting ions in each of said peripheral regions such that implanted ions are substantially excluded from each of said central regions and conductivity of the first type is imparted to each of said peripheral regions, said implantation step resulting, in the completed transistor, in an abutment between the peripheral region of the emitter layer and the central emitter region; and
k) after (j), removing the peripheral portion of the emitter contact layer.
